# EUROPÄISCHE PATENTSCHRIFT

(11) **EP 2 668 821 B1**
(45) Veröffentlichungstag und Bekanntmachung des Hinweises auf die Patenterteilung: **27.07.2016**
(21) Anmeldenummer: 12701850.5
(22) Anmeldetag: 18.01.2012
(51) Int. Cl.: H05B 33/08, H01L 27/15

(54) **LEUCHTMODUL ZUR ABSTRAHLUNG VON MISCHLICHT**
LIGHTING MODULE FOR EMITTING MIXED LIGHT
MODULE LUMINEUX PERMETTANT D'ÉMETTRE DE LA LUMIÈRE MIXTE

(30) Priorität: 28.01.2011 DE 102011009697
(43) Veröffentlichungstag der Anmeldung: 04.12.2013
(73) Patentinhaber: OSRAM Opto Semiconductors GmbH, 93055 Regensburg (DE)
(72) Erfinder: GÄRTNER, Christian, 93073 Neutraubling (DE); MARKYTAN, Ales, 93055 Regensburg (DE); MARFELD, Jan, 93055 Regensburg (DE)
(74) Vertreter: Epping - Hermann - Fischer
(86) Internationale Anmeldenummer: PCT/EP2012/050722
(87) Internationale Veröffentlichungsnummer: WO 2012/101022

(56) Entgegenhaltungen:
- DE-A1-102008 057 347
- US-A1- 2007 171 159
- US-A1- 2008 111 505

## Beschreibung

Es wird ein Leuchtmodul zur Abstrahlung von Mischlicht angegeben, das mehrere Halbleiterbauelemente aufweist, die Licht verschiedener Wellenlänge emittieren. Insbesondere erzeugt das Leuchtmodul im Betrieb weißes Licht.

Beleuchtungseinrichtungen, die mischfarbiges Licht abstrahlen, sind beispielsweise in den Druckschriften DE 102008057347, US 2008/0111505 und US 2007/0171159 beschrieben.

Beleuchtungseinrichtungen, die weißes Licht abstrahlen, können beispielsweise durch die Kombination einer oder mehrerer rot emittierender LEDs mit einer oder mehreren so genannten Konversions-LEDs erreicht werden, die blaues Licht erzeugen, das in einer Konversionsschicht in Licht mit einer anderen Wellenlänge, beispielsweise grünlich-weißes Licht, umgewandelt wird. Der jeweilige Betriebsstrom der verwendeten LEDs wird derart angepasst, dass die Überlagerung des von allen LEDs emittierten Lichts weißes Licht auf der Weißkurve eines Planck'schen Schwarzkörperstrahlers ergibt.

Problematisch ist im Betrieb der Beleuchtungseinrichtung das unterschiedliche Temperatur- und Alterungsverhalten der rot und grünlich-weiß emittierenden LEDs, was zur Folge hat, dass der Farbort der Beleuchtungseinrichtung aufgrund der Temperaturabhängigkeit schwer zu stabilisieren ist.

Eine zu lösende Aufgabe besteht vorliegend darin, ein Leuchtmodul mit einem vergleichsweise temperaturstabilen Farbort anzugeben.

Gemäß einer bevorzugten Ausführungsform umfasst das zur Abstrahlung von Mischlicht vorgesehene Leuchtmodul mindestens ein erstes Halbleiterbauelement, das unkonvertiertes rotes Licht abstrahlt, mindestens ein zweites Halbleiterbauelement, das konvertiertes grünlich-weißes Licht mit einem ersten Konversionsanteil abstrahlt, und mindestens ein drittes Halbleiterbauelement, das konvertiertes grünlich-weißes Licht mit einem zweiten Konversionsanteil abstrahlt, der kleiner ist als der erste Konversionsanteil. Das mindestens eine zweite und dritte Halbleiterbauelement umfassen hierbei jeweils ein Konversionselement, wobei die Konversionselemente einen positiven Temperaturkoeffizienten aufweisen. Gemäß einer nicht beanspruchten Abwandlung können die Konversionselemente hingegen auch einen negativen Temperaturkoeffizienten aufweisen.

Weiterhin umfasst das Leuchtmodul mindestens ein Widerstandselement mit einem temperaturabhängigen elektrischen Widerstand, wobei das Widerstandselement einen positven Temperaturkoeffizienten aufweist (sogenannter PTC - Widerstand). Gemäß einer nicht beanspruchten Abwandlung kann das Widerstandselement hingegen auch einen negativen Temperaturkoeffizienten aufweisen (sogenannter NTC-Widerstand).

Ferner bildet das zweite Halbleiterbauelement mit dem Widerstandselement eine Serienschaltung. Weiterhin ist die Serienschaltung mit einem Strang, der das mindestens eine erste Halbleiterbauelement umfasst, und mit einem weiteren Strang, der das mindestens eine dritte Halbleiterbauelement umfasst, oder mit einem Strang, der das mindestens eine erste Halbleiterbauelement in Serie mit dem mindestens einen dritten Halbleiterbauelement umfasst, parallel geschaltet.

Der zweite Konversionsanteil des von dem dritten Halbleiterbauelement emittierten Lichts kann gegen Null gehen, sodass das dritte Halbleiterbauelement blaues Licht emittiert.

Durch die Parallelschaltung des zweiten Halbleiterbauelements relativ zu dem dritten Halbleiterbauelement kann vorteilhafterweise durch das zweite Halbleiterbauelement ein anderer Strom fließen als durch das dritte Halbleiterbauelement. Somit können durch eine geeignete Bestromung der beiden Halbleiterbauelemente der erste und der zweite Konversionsanteil sowie der gesamte Konversionsanteil entsprechend eingestellt werden.

Das erste Halbleiterbauelement ist mit dem Widerstandselement, dem zweiten und dem dritten Halbleiterbauelement derart verschaltet, dass ein Farbort des Mischlichts bei zunehmender Temperatur stabil ist.

Das erste Halbleiterbauelement kann beispielsweise einen rot emittierenden InGaAlP-Halbleiterchip umfassen. Hierbei tritt das Problem auf, dass die Lichtintensität mit steigender Temperatur abnimmt. Weiterhin können die zweiten und dritten Halbleiterbauelemente InGaN-Halbleiterchips aufweisen, bei welchen sich die Lichtintensität mit zunehmender Temperatur weniger stark ändert als im Falle des InGaAlP-Halbleiterchips. Somit würde sich bei einem Temperaturanstieg der Farbort des Mischlichts in Richtung blauer Farbkoordinaten verschieben.

Ferner umfassen die zweiten und dritten Halbleiterbauelemente jeweils ein Konversionselement mit mindestens einem Konversionsstoff.

Bei einem Konversionselement mit negativem Temperaturkoeffizienten tritt das Problem auf, dass das Konversionselement mit steigender Temperatur weniger effizient ist. Dadurch ist es möglich, dass sich mit steigender Temperatur der Farbort des zweiten und dritten Halbleiterbauelements in Richtung blauer Farbortkoordinaten verschiebt.

Ein Konversionselement mit positivem Temperaturkoeffizienten ist mit steigender Temperatur effizienter, da der Konversionsanteil aufgrund vermehrter Streuung zunimmt. Dadurch ist es möglich, dass sich mit steigender Temperatur der Farbort des zweiten und dritten Halbleiterbauelements in Richtung grüner Farbortkoordinaten verschiebt.

Mittels des temperaturabhängigen elektrischen Widerstands kann vorteilhafterweise der Betriebsstrom zumindest eines der Halbleiterbauelemente des Leuchtmoduls in Abhängigkeit der Temperatur geändert werden, um die Farbortkoordinaten des Mischlichts bei Temperaturänderungen zu stabilisieren.

Vorteilhafterweise ist das Leuchtmodul schaltungstechnisch derart aufgebaut, dass ein 1-Kanaltreiber zum Betreiben des gesamten Leuchtmoduls ausreicht.

In einer nicht beanspruchten Abwandlung umfasst das Leuchtmodul einen Strang mit dem Widerstandselement und dem dritten Halbleiterbauelement, wobei das Widerstandselement eine Serienschaltung mit dem dritten Halbleiterbauelement bildet. Insbesondere weist das Widerstandselement bei dieser Ausgestaltung einen positiven Temperaturkoeffizienten auf (sogenannter PTC - Widerstand), wenn das Konversionselement einen negativen Temperaturkoeffizienten aufweist. Der elektrische Widerstand des Widerstandselements nimmt mit steigender Temperatur zu, sodass weniger Strom durch das dritte Halbleiterbauelement fließt. Zugleich nimmt der Strom durch das erste Halbleiterbauelement bei steigender Temperatur ab. Mittels des Widerstandselements mit positivem Temperaturkoeffizienten kann die Lichtintensität des von dem dritten Halbleiterbauelement abgestrahlten Lichts reduziert werden, so dass einer temperaturbedingten Verschiebung des Farborts des Mischlichts in Richtung blauer Farbkoordinaten aufgrund der Abnahme des Rotanteils entgegengewirkt werden kann. Zugleich wird durch die sinkende Bestromung des dritten Halbleiterbauelements, das gegenüber dem zweiten Hallbleiterbauelement einen größeren blauen Primärlichtanteil aufweist, weniger blaues Licht erzeugt, so dass einer Verschiebung des Farborts des Mischlichts aufgrund sinkender Effizienz des Konversionsstoffs entgegengewirkt wird.

Bei dieser Abwandlung ist es möglich, dass das erste und das zweite Halbleiterbauelement eine Parallelschaltung oder eine Serienschaltung bilden.

Wenn das Konversionselement einen positiven Temperaturkoeffizienten aufweist und das Leuchtmodul einen Strang mit dem Widerstandselement und dem zweiten Halbleiterbauelement umfasst, wobei das Widerstandselement einen positven Temperaturkoeffizienten aufweist, fließt bei zunehmender Temperatur weniger Strom durch das zweite Halbleiterbauelement, so dass einer Zunahme des grünen Konversionsanteils entgegengewirkt werden kann. Dadurch wird ferner einer temperaturbedingten Verschiebung des Farborts des Mischlichts in Richtung grüner Farbkoordinaten entgegengewirkt. Bei dieser Ausführungsform nimmt zugleich der Strom durch das erste Halbleiterbauelement bei steigender Temperatur ab.

Eine nicht beanspruchte, alternative Ausführungsform sieht einen Strang vor umfassend das Widerstandselement sowie das erste und zweite Halbleiterbauelement, wobei das Widerstandselement eine Serienschaltung mit dem ersten und zweiten Halbleiterbauelement bildet und einen negativen Temperaturkoeffizienten aufweist (sogenannter NTC-Widerstand). Vorzugsweise bilden das erste und das zweite Halbleiterbauelement bei dieser Abwandlung eine Serienschaltung. Weiterhin weist das Konversionselement hierbei insbesondere einen negativen Temperaturkoeffizienten auf.

Mit steigender Temperatur nimmt der Widerstand des Widerstandselements ab, sodass mehr Strom durch das erste und zweite Halbleiterbauelement fließt, wodurch bei höheren Temperaturen einer Abnahme der Lichtintensität des von dem ersten Halbleiterbauelement abgestrahlten Lichts entgegengewirkt werden kann. Zugleich kann durch Erhöhung des Stroms durch das zweite Halbleiterbauelement mehr blaues Licht erzeugt und umgewandelt werden, sodass einer Farbortverschiebung in Richtung blauer Farbortkoordinaten aufgrund eines temperaturbedingten Effizienzabfalls des Konversionselements entgegengewirkt werden kann.

Bei einer weiteren, nicht beanspruchten Abwandlung weist im Fall eines Konversionselements mit positivem Temperaturkoeffizienten das Leuchtmodul mit Vorteil einen Strang umfassend das Widerstandselement sowie das erste und dritte Halbleiterbauelement auf, wobei das Widerstandselement eine Serienschaltung mit dem ersten und dritten Halbleiterbauelement bildet und einen negativen Temperaturkoeffizienten aufweist. Vorzugsweise bilden das erste und das dritte Halbleiterbauelement bei dieser Ausführungsform eine Serienschaltung.

Der beschriebene Effekt kann auch bei einer weiteren, nicht beanspruchten Abwandlung erzielt werden, bei welchem das Konversionselement einen negativen Temperaturkoeffizienten aufweist. Hierbei weist das Leuchtmodul ein erstes Widerstandselement mit einem negativen Temperaturkoeffizienten und ein zweites Widerstandselement mit einem negativen Temperaturkoeffizienten auf, wobei das erste Widerstandselement mit dem ersten Halbleiterbauelement und das zweite Widerstandselement mit dem zweiten Halbleiterbauelement eine Serienschaltung bildet. Vorzugsweise umfasst ein erster Strang das erste Widerstandselement und das erste Halbleiterbauelement, während ein zweiter Strang das zweite Widerstandselement und das zweite Halbleiterbauelement aufweist, wobei der erste und der zweite Strang eine Parallelschaltung bilden.

Bei einer weiteren, nicht beanspruchten Abwandlung weist im Fall eines Konversionselements mit positivem Temperaturkoeffizienten das Leuchtmodul mit Vorteil ein erstes Widerstandselement mit einem negativen Temperaturkoeffizienten und ein zweites Widerstandselement mit einem negativen Temperaturkoeffizienten auf, wobei das erste Widerstandselement mit dem ersten Halbleiterbauelement und das zweite Widerstandselement mit dem dritten Halbleiterbauelement eine Serienschaltung bildet. Vorzugsweise umfasst ein erster Strang das erste Widerstandselement und das erste Halbleiterbauelement, während ein zweiter Strang das zweite Widerstandselement und das dritte Halbleiterbauelement aufweist, wobei der erste und der zweite Strang eine Parallelschaltung bilden.

Vorzugsweise ist bei den beschriebenen Leuchtmodulen mindestens eines der ersten, zweiten und dritten Halbleiterbauelemente nicht mit einem Widerstandselement mit temperaturabhängigem elektrischen Widerstand in Serie geschaltet.

Bei allen Ausführungsformen sowie Abwandlungen weist das von dem Leuchtmodul emittierte Mischlicht, insbesondere in einem Temperaturbereich zwischen -40°C und 150°C, einen vergleichsweise stabilen Farbort auf.

Vorzugsweise wird vorliegend Mischlicht mit einer Farbtemperatur zwischen 2400 K und 7000 K als weißes Licht oder Licht mit einem weißen Leucht- oder Farbeindruck bezeichnet.

Gemäß einer bevorzugten Ausführungsform beträgt das Verhältnis eines von den zweiten Halbleiterbauelementen erzeugten Gesamtlichtstroms zu dem von den dritten Halbleiterbauelementen erzeugten Gesamtlichtstrom zwischen 1:4 und 4:1. Insbesondere ist das Verhältnis so gewählt, dass das von dem Leuchtmodul erzeugte Mischlicht weißes Licht ergibt. Auch die Anzahl der rotes Licht emittierenden ersten Halbleiterbauelemente wird abhängig vom Zielfarbort des Leuchtmoduls gewählt.

Gemäß einer bevorzugten Ausgestaltung wird der in dem weißen Licht enthaltene Rotanteil von einem Halbleiterchip mit einer Halbleiterschichtenfolge auf der Basis von InGaAlP erzeugt. "Auf der Basis von InGaAlP" bedeutet in diesem Zusammenhang, dass die Halbleiterschichtenfolge AlₙGaₘIn₁₋ₙ₋ₘP umfasst, wobei 0 ≤ n ≤ 1, 0 ≤ m ≤ 1 und n+m ≤ 1. Insbesondere weist das rote Licht eine dominante Wellenlänge zwischen 600 nm und 680 nm, vorzugsweise zwischen 615 nm und 660 nm, auf.

Weiterhin wird der in dem weißen Mischlicht enthaltene grünlich-weiße Anteil vorzugsweise von Halbleiterchips mit einer Halbleiterschichtenfolge auf der Basis von InGaN erzeugt. "Auf der Basis von InGaN" bedeutet in diesem Zusammenhang, dass die Halbleiterschichtenfolge GaₘIn₁₋ₘN umfasst, wobei 0 ≤ m ≤ 1.

Zur Erzeugung des Konversionsanteils weisen das zweite und dritte Halbleiterbauelement jeweils ein Konversionselement auf. Das Konversionselement enthält mindestestens einen Konversionsstoff zur Umwandlung eines Teils des von dem Halbleiterchip erzeugten Primärlichts in Sekundärlicht. Als Konversionsstoff kommt insbesondere ein auf YAG-basierender Leuchtstoff in Frage. Beispielsweise ist der Konversionsstoff in ein Matrixmaterial wie Silikon eingebettet.

Die für das zweite und dritte Halbleiterbauelement vewendeten Konversionselemente weisen vorzugsweise den gleichen Konversionsstoff auf. Beispielsweise kann die Konzentration des Konversionsstoffs im Falle des dritten Halbleiterbauelements geringer sein als im Falle des zweiten Halbleiterbauelements, sodass das von dem zweiten Halbleiterbauelement abgestrahlte Licht einen höheren Konversionsanteil aufweist als das von dem dritten Halbleiterbauelement abgestrahlte Licht. Weiterhin kann die Dicke des Konversionselements im Falle des zweiten Halbleiterbauelements größer sein, sodass die Weglänge innerhalb des Konversionselements größer ist und damit zu einem höheren Konversionsanteil führt als im Falle des dritten Halbleiterbauelements.

Gemäß der ersten Variante weist das Konversionselement einen negativen Temperaturkoeffizienten auf. In diesem Fall enthält das Konversionselemenet insbesondere kein Füllmaterial.

Gemäß der zweiten Variante weist das Konversionselement einen positiven Temperaturkoeffizienten auf. In diesem Fall kann in das Matrixmaterial zusätzlich zum Konversionsstoff ein Füllmaterial eingebettet sein. Mit Vorteil wird ein Füllmaterial verwendet, das bei Raumtemperatur einen ähnlichen Brechungsindex wie das Matrixmaterial aufweist und dessen Brechungsindex bei steigender Temperatur konstant bleibt, während der Brechungsindex des Matrixmaterials abnimmt. Insbesondere ist der Unterschied zwischen den Brechungsindizes bei Raumtemperatur nicht größer als 0.03. Das Füllmaterial kann beispielsweise Glaspartikel wie SiO2-Partikel oder Keramikpartikel wie Al2O3-Partikel umfassen, während das Matrixmaterial zum Beispiel Silikon enthält. Bei steigender Temperatur tritt aufgrund des zunehmenden Brechungsindexunterschieds zwischen Füllmaterial und Matrixmaterial vermehrt Streuung auf, was zu mehr Konversion führt.

Gemäß einer bevorzugten Ausführungsform weist das von dem zweiten Halbleiterbauelement abgestrahlte Licht einen Farbort mit den Farbkoordinaten cx zwischen 0.37 und 0.45 und cy zwischen 0.44 und 0.61 auf. Weiterhin weist das von dem dritten Halbleiterbauelement abgestrahlte Licht vorzugsweise einen Farbort mit den Farbkoordinaten cx zwischen 0.1 und 0.31 und cy zwischen 0.1 und 0.32 auf.

Gemäß einer vorteilhaften Weiterbildung weist das Leuchtmodul mindestens ein viertes Halbleiterbauelement auf, das sich durch Lichtintensität und/oder Farbort des abgestrahlten Lichts von dem ersten, zweiten und dritten Halbleiterbauelement unterscheidet. Hierdurch kann beispielsweise die Lichtausbeute, die Lichtintensität oder die Farbwiedergabe des Leuchtmoduls verbessert werden.

Bei einer bevorzugten Ausgestaltung bildet das vierte Halbleiterbauelement mit einer Anordnung, welche das mindestens eine erste, zweite und dritte Halbleiterbauelement sowie das mindestens eine Widerstandselement umfasst, eine Serienschaltung. Dadurch fällt das Widerstandselement spannungstechnisch weniger stark ins Gewicht.

Gemäß einer vorteilhaften Ausführungsform bildet das vierte Halbleiterbauelement mit einer Anordnung, welche das mindestens eine erste, zweite und dritte Halbleiterbauelement sowie das mindestens eine Widerstandselement umfasst, eine Parallelschaltung. Bei einer großen Anzahl von Halbleiterbauelementen können dadurch zu hohe Spannungen vermieden werden. Weiterhin kann durch Zuschalten von vierten Halbleiterbauelementen vorteilhafterweise eine Anpassung an die Treiberelektronik vorgenommen werden.

Insgesamt kann durch Zuschalten von mindestens einem vierten Halbleiterbauelement die Effizienz des Gesamtsystems verbessert werden.

Ist das vierte Halbleiterbauelement zum verbesserten schaltungstechnischen Betreiben des Leuchtmoduls vorgesehen, so ist es vorteilhaft, wenn das vierte Halbleiterbauelement monochromatisches Licht in einem Wellenlängenbereich zwischen insbesondere 450 nm und 600 nm emittiert.

Ist das vierte Halbleiterbauelement zur Verbesserung der Farbwiedergabe des von dem Leuchtmodul abgestrahlten Mischlichts vorgesehen, so ist es vorteilhaft, wenn das vierte Halbleiterbauelement konvertiertes, insbesondere gelbes Licht aussendet.

Gemäß einer bevorzugten Ausführungsform weist das Leuchtmodul mindestens ein Widerstandselement mit einem temperaturunabhängigen elektrischen Widerstand auf, was bedeutet, dass der elektrische Widerstand über weite Temperaturbereiche hinweg, insbesondere zwischen -40°C und 150°C, annähernd konstant ist. Dies gilt beispielsweise nicht für das oben genannte Widerstandselement mit temperaturabhängigem Widerstand, das einen positiven oder negativen Temperaturkoeffizienten aufweist, wobei der elektrische Widerstand mit steigender Temperatur größer oder kleiner wird und entsprechend nicht konstant ist.

Insbesondere weist das Widerstandselement mit temperaturunabhängigem elektrischem Widerstand einen ohmschen Widerstand auf.

Das mindestens eine Widerstandselement mit temperaturunabhängigem elektrischem Widerstand kann innerhalb eines Strangs, der das erste, zweite oder dritte Halbleiterbauelement umfasst, angeordnet und mit mindestens einem dieser Halbleiterbauelemente in Serie geschaltet sein.

Bei einer vorteilhaften Weiterbildung weist das Leuchtmodul mindestens zwei Widerstandselemente mit einem temperaturunabhängigen elektrischen Widerstand auf, wobei jedes Halbleiterbauelement mit einem Widerstandselement eine Serienschaltung bildet.

Gemäß einer bevorzugten Ausgestaltung weist das mindestens eine Widerstandselement mit temperaturunabhängigem elektrischen Widerstand einen programmierbaren elektrischen Widerstand auf. Der elektrische Widerstand kann in das Widerstandselement fest einprogrammiert werden, sodass sich bei dem Leuchtmodul ein dauerhafter Offset des Farborts ergibt. Durch einen dauerhaften Offset des Farborts können beispielsweise Fertigungstoleranzen oder Sättigungsschwankungen ausgeglichen werden.

Bei einer vorteilhaften Ausführungsform weist das Leuchtmodul mehrere erste, mehrere zweite und mehrere dritte Halbleiterbauelemente auf, wobei die Halbleiterbauelemente gleicher Art eine Serienschaltung bilden. Die Halbleiterbauelemente gleicher Art senden gleichfarbiges Licht aus. Das Leuchtmodul kann einen ersten Strang mit mehreren ersten und zweiten, in Serie geschalteten Halbleiterbauelementen und einen zweiten Strang mit mehreren dritten, in Serie geschalteten Halbleiterbauelementen aufweisen. Alternativ kann das Leuchtmodul einen ersten Strang mit mehreren ersten in Serie geschalteten Halbleiterbauelementen, einen zweiten Strang mit mehreren zweiten, in Serie geschalteten Halbleiterbauelementen und einen dritten Strang mit mehreren dritten, in Serie geschalteten Halbleiterbauelementen aufweisen.

Im Folgenden wird das hier beschriebene Leuchtmodul anhand von Ausführungsbeispielen und den dazugehörigen Figuren näher erläutert.

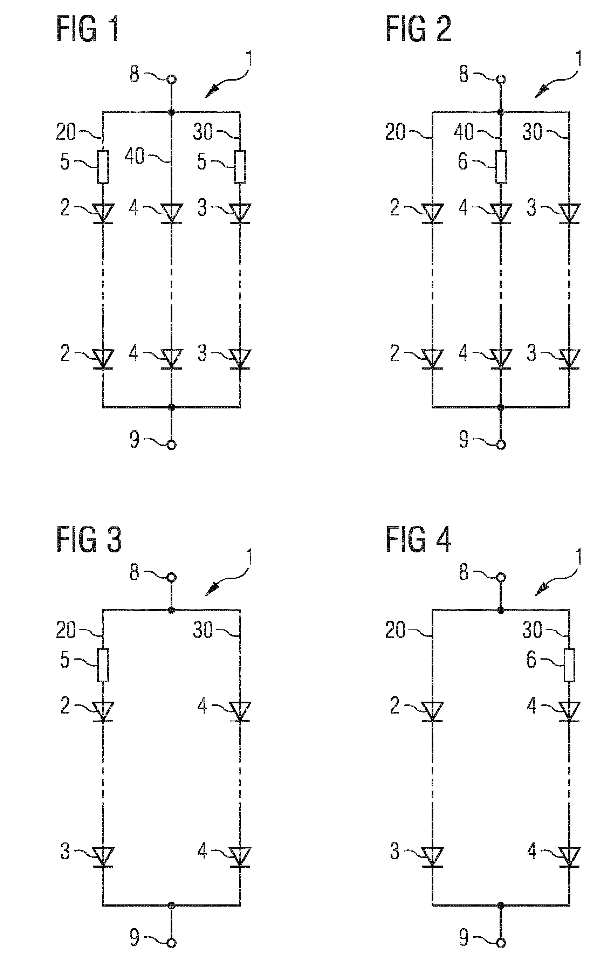

Die Figuren 1 bis 7 zeigen Ersatzschaltbilder verschiedener Ausführungsbeispiele des hier beschriebenen Leuchtmoduls sowie nicht beanspruchter Abwandlungen.

Gleiche, gleichartige oder gleich wirkende Elemente sind in den Figuren mit denselben Bezugszeichen versehen.

In Figur 1 ist ein Ersatzschaltbild einer nicht beanspruchten Abwandlung eines Leuchtmoduls 1 gemäß der vorliegenden Anmeldung dargestellt.

Das Leuchtmodul 1 umfasst mehrere erste Halbleiterbauelemente 2, mehrere zweite Halbleiterbauelemente 3 sowie mehrere dritte Halbleiterbauelemente 4.

Alle ersten Halbleiterbauelemente 2 sind innerhalb eines ersten Strangs 20 angeordnet und bilden eine Serienschaltung. Weiterhin sind alle zweiten Halbleiterbauelemente 3 innerhalb eines zweiten Strangs 30 angeordnet und bilden eine Serienschaltung. Ferner sind alle dritten Halbleiterbauelemente 4 innerhalb eines dritten Strangs 40 angeordnet und bilden eine Serienschaltung. Die gestrichelten Linien symbolisieren mögliche weitere Halbleiterbauelemente. Die drei Stränge 20, 30, 40 sind zueinander parallel geschaltet.

Die ersten Halbleiterbauelemente 2 umfassen vorzugsweise jeweils einen Halbleiterchip mit einer Halbleiterschichtenfolge auf der Basis von InGaAlP.

Weiterhin umfassen die zweiten und dritten Halbleiterbauelemente 3, 4 vorzugsweise jeweils einen Halbleiterchip mit einer Halbleiterschichtenfolge auf der Basis von InGaN. Zur Erzeugung des Konversionsanteils weisen die zweiten und dritten Halbleiterbauelemente 3, 4 jeweils ein Konversionselement auf. Das Konversionselement enthält mindestestens einen Konversionsstoff zur Umwandlung eines Teils des von dem Halbleiterchip erzeugten Primärlichts in Sekundärlicht. Als Konversionsstoff kommt insbesondere ein auf YAG-basierender Leuchtstoff in Frage. Das Konversionselement kann in Form eines Plättchens direkt auf einer Strahlungsaustrittsseite der Halbleiterchips angeordnet sein. Die für das zweite und dritte Halbleiterbauelement 3, 4 vewendeten Konversionselemente weisen vorzugsweise den gleichen Konversionsstoff auf. Insbesondere weisen die zweiten und dritten Halbleiterbauelemente 3, 4 bei der in Figur 1 dargestellten Abwandlung jeweils ein Konversionselement mit einem negativen Temperaturkoeffizienten auf.

Das Leuchtmodul 1 weist ein erstes und ein zweites Widerstandselement 5 auf. Das erste Widerstandselement 5 ist innerhalb des ersten Strangs 20 angeordnet und bildet eine Serienschaltung mit den ersten Halbleiterbauelementen 2. Das zweite Widerstandselement 5 ist innerhalb des zweiten Strangs 30 angeordnet und bildet eine Serienschaltung mit den zweiten Halbleiterbauelementen 3. Die beiden Widerstandselemente 5 weisen einen temperaturabhängigen elektrischen Widerstand auf. Bei der in Figur 1 dargestellten Abwandlung weisen die beiden Widerstandselemente 5 einen negativen Temperaturkoeffizienten auf. In dem dritten Strang 40 befindet sich kein Widerstandselement mit temperaturabhängigem Widerstand.

Das Leuchtmodul 1 wird im Betrieb über zwei elektrische Anschlüsse 8, 9 mit Strom versorgt. Hierbei emittieren die ersten Halbleiterbauelemente 2 unkonvertiertes rotes Licht. Die zweiten Halbleiterbauelemente 3 emittieren konvertiertes grünlich-weißes Licht mit einem ersten Konversionsanteil. Die dritten Halbleiterbauelemente 4 emittieren konvertiertes grünlich-weißes Licht mit einem zweiten Konversionsanteil, der kleiner ist als der erste Konversionsanteil.

Insbesondere weist das rote Licht eine dominante Wellenlänge zwischen 600 nm und 660 nm, vorzugsweise zwischen 615 nm und 660 nm, auf. Weiterhin weist das von dem zweiten Halbleiterbauelement 3 abgestrahlte Licht einen Farbort mit den Farbkoordinaten cx zwischen 0.37 und 0.45 und cy zwischen 0.44 und 0.61 auf. Ferner weist das von dem dritten Halbleiterbauelement 4 abgestrahlte Licht vorzugsweise einen Farbort mit den Farbkoordinaten cx zwischen 0.1 und 0.31 und cy zwischen 0.1 und 0.32 auf.

Das von dem Leuchtmodul 1 emittierte Mischlicht weist eine Farbtemperatur zwischen 2400 K und 7000 K auf.

Im Betrieb des Leuchtmoduls 1 nimmt die Temperatur des Systems zu. Mit zunehmender Temperatur nimmt der elektrischee Widerstand der beiden Widerstandselemente 5 ab. Somit kann durch den ersten und zweiten Strang 20, 30 mehr Strom fließen. Dadurch kann einer Abnahme der Lichtintensität des von den ersten Halbleiterbauelementen 2 erzeugten roten Lichts entgegengewirkt werden. Zugleich kann einer Abnahme des Konversionsanteils des von den zweiten Halbleiterbauelementen 3 erzeugten Lichts entgegengewirkt werden.

Mittels der beiden Widerstandselemente 5 kann somit einer Farbortverschiebung des Mischlichts in Richtung blauer Farbkoordinaten bei zunehmender Temperatur entgegengewirkt werden.

Werden zweite und dritte Halbleiterbauelemente 3, 4 verwendet, die jeweils ein Konversionselement mit positivem Temperaturkoeffizienten aufweisen, so sind die zweiten Halbleiterbauelemente 3 mit den dritten Halbleiterbauelementen 4 vertauscht. Der zweite Strang 30 weist dann die dritten Halbleiterbauelemente 4 sowie das Widerstandselement 5 mit negativem Temperaturkoeffizienten auf. Der dritte Strang 40 weist nur die zweiten Halbleiterbauelemente 3 auf.

Mittels der beiden Widerstandselemente 6 kann dann einer Farbortverschiebung des Mischlichts in Richtung grüner Farbkoordinaten bei zunehmender Temperatur entgegengewirkt werden.

In Figur 2 ist das Ersatzschaltbild einer weiteren nicht beanspruchten Abwandlung eines Leuchtmoduls 1 dargestellt.

Das Leuchtmodul 1 weist mehrere erste Halbleiterbauelemente 2, mehrere zweite Halbleiterbauelemente 3 und mehrere dritte Halbleiterbauelemente 4 auf. Diese weisen Eigenschaften auf wie sie bereits im Zusammenhang mit Figur 1 beschrieben wurden. Die drei Stränge 20, 30, 40 aus verschiedenfarbigen Halbleiterbauelementen 2, 3, 4 sind zueinander parallel geschaltet.

Das Leuchtmodul 1 weist ein Widerstandselement 6 mit einem temperaturabhängigen elektrischen Widerstand auf. Das Widerstandselement 6 ist innerhalb des dritten Strangs 40 angeordnet und bildet eine Serienschaltung mit den dritten Halbleiterbauelementen 4. Das Widerstandselement 6 weist einen positiven Temperaturkoeffizienten auf.

Mit zunehmender Temperatur steigt im Betrieb der elektrische Widerstand des Widerstandselements 6 an. Somit nimmt der Stromfluss durch die dritten Halbleiterbauelemente 4 ab. Dadurch nimmt die Lichtintensität des von den dritten Halbleiterbauelementen 4 erzeugten Lichts ab. Das grünlich-weiße Licht wird also entsprechend dem roten Licht abgeschwächt. Zugleich wird der blaue Primärlichtanteil reduziert. Dies gilt für den Fall, dass die zweiten und dritten Halbleiterbauelemente 3, 4 jeweils ein Konversionselement mit negativem Temperaturkoeffizienten aufweisen.

Mittels des Widerstandselements 6 kann somit einer Farbortverschiebung des Mischlichts in Richtung blauer Farbkoordinaten bei zunehmender Temperatur entgegengewirkt werden.

Die Figur 2 zeigt ferner das Ersatzschaltbild eines beanspruchten Ausführungsbeispiels eines Leuchtmoduls 1 unter Vertauschung der zweiten mit den dritten Halbleiterbauelementen 3, 4. Hierbei werden zweite und dritte Halbleiterbauelemente 3, 4 verwendet, die jeweils ein Konversionselement mit positivem Temperaturkoeffizienten aufweisen. Der zweite Strang 30 weist dann nur die dritten Halbleiterbauelemente 4 auf. Der dritte Strang 40 weist die zweiten Halbleiterbauelemente 3 sowie das Widerstandselement 6 mit positivem Temperaturkoeffizienten auf.

Mittels des Widerstandselements 6 kann dann einer Farbortverschiebung des Mischlichts in Richtung grüner Farbkoordinaten bei zunehmender Temperatur entgegengewirkt werden.

In Figur 3 ist das Ersatzschaltbild einer weiteren nicht beanspruchten Abwandlung eines Leuchtmoduls 1 gemäß der vorliegenden Anmeldung dargestellt.

Das Leuchtmodul 1 weist mehrere erste Halbleiterbauelemente 2, mehrere zweite Halbleiterbauelemente 3 und mehrere dritte Halbleiterbauelemente 4 auf. Diese weisen Eigenschaften auf wie sie bereits im Zusammenhang mit Figur 1 beschrieben wurden.

Der erste Strang 20 umfasst die ersten Halbleiterbauelemente 2 und die zweiten Halbleiterbauelemente 3. Innerhalb des ersten Strangs 20 sind alle Halbleiterbauelemente 2, 3 seriell verschaltet. Der zweite Strang 30 umfasst nur die dritten Halbleiterbauelemente 4. Die beiden Stränge 20, 30 sind zueinander parallel geschaltet.

Das Leuchtmodul 1 weist ein Widerstandselement 5 mit einem temperaturabhängigen elektrischen Widerstand auf. Das Widerstandselement 5 ist innerhalb des ersten Strangs 20 angeordnet und bildet eine Serienschaltung mit den ersten und zweiten Halbleiterbauelementen 2, 3. Das Widerstandselement 5 weist einen negativen Temperaturkoeffizienten auf.

Mit zunehmender Temperatur nimmt im Betrieb der elektrische Widerstand des Widerstandselements 5 ab. Somit kann durch den ersten Strang 20 mehr Strom fließen. Dadurch kann einer Abnahme der Lichtintensität des von den Halbleiterbauelementen 2 erzeugten roten Lichts entgegengewirkt werden. Zugleich kann einer Abnahme des Konversionsanteils des von den zweiten Halbleiterbauelementen 3 erzeugten Lichts entgegengewirkt werden. Dies gilt für den Fall, dass die zweiten und dritten Halbleiterbauelemente 3, 4 jeweils ein Konversionselement mit negativem Temperaturkoeffizienten aufweisen.

Mittels des Widerstandselements 5 kann somit einer Farbortverschiebung des Mischlichts in Richtung blauer Farbkoordinaten bei zunehmender Temperatur entgegengewirkt werden.

Werden zweite und dritte Halbleiterbauelemente 3, 4 verwendet, die jeweils ein Konversionselement mit positivem Temperaturkoeffizienten aufweisen, so sind die zweiten Halbleiterbauelemente 3 mit den dritten Halbleiterbauelementen 4 vertauscht. Der erste Strang 20 weist dann statt den zweiten Halbleiterbauelementen 3 dritte Halbleiterbauelemente 4 auf. Ferner weist der zweite Strang 30 statt den dritten Halbleiterbauelementen 4 zweite Halbleiterbauelemente 3 auf.

Mittels des Widerstandselements 6 kann dann einer Farbortverschiebung des Mischlichts in Richtung grüner Farbkoordinaten bei zunehmender Temperatur entgegengewirkt werden.

In Figur 4 ist das Ersatzschaltbild einer weiteren nicht beanspruchten Abwandlung eines Leuchtmoduls 1 dargestellt.

Das Leuchtmodul 1 weist mehrere erste Halbleiterbauelemente 2, mehrere zweite Halbleiterbauelemente 3 und mehrere dritte Halbleiterbauelemente 4 auf. Diese weisen Eigenschaften auf wie sie bereits im Zusammenhang mit Figur 1 beschrieben wurden.

Der erste Strang 20 umfasst die ersten Halbleiterbauelemente 2 und die zweiten Halbleiterbauelemente 3. Innerhalb des ersten Strangs 20 sind alle Halbleiterbauelemente 2, 3 seriell verschaltet. Der zweite Strang 30 umfasst die dritten Halbleiterbauelemente 4, die in Serie geschaltet sind. Die beiden Stränge 20, 30 sind zueinander parallel geschaltet.

Das Leuchtmodul 1 weist ein Widerstandselement 6 mit einem temperaturabhängigen elektrischen Widerstand auf. Das Widerstandselement 6 ist innerhalb des zweiten Strangs 30 angeordnet und bildet eine Serienschaltung mit den dritten Halbleiterbauelementen 4. Das Widerstandselement 6 weist einen positiven Temperaturkoeffizienten auf.

Mit zunehmender Temperatur steigt im Betrieb der elektrische Widerstand des Widerstandselements 6 an. Somit nimmt der Stromfluss durch die dritten Halbleiterbauelemente 4 ab. Dadurch nimmt die Lichtintensität des von den dritten Halbleiterbauelementen 4 erzeugten Lichts ab. Das grünlich-weiße Licht wird also entsprechend dem roten Licht abgeschwächt. Zugleich wird der blaue Primärlichtanteil reduziert. Dies gilt für den Fall, dass die zweiten und dritten Halbleiterbauelemente 3, 4 jeweils ein Konversionselement mit negativem Temperaturkoeffizienten aufweisen.

Mittels des Widerstandselements 6 kann somit einer Farbortverschiebung des Mischlichts in Richtung blauer Farbkoordinaten bei zunehmender Temperatur entgegengewirkt werden.

Ferner zeigt Figur 4 das Ersatzschaltbild eines beanspruchten Ausführungsbeispiels eines Leuchtmoduls 1 unter Vertauschung der zweiten mit den dritten Halbleiterbauelementen 3, 4. Hierbei werden zweite und dritte Halbleiterbauelemente 3, 4 verwendet, die jeweils ein Konversionselement mit positivem Temperaturkoeffizienten aufweisen. Der erste Strang 20 weist dann statt den zweiten Halbleiterbauelementen 3 dritte Halbleiterbauelemente 4 auf. Ferner weist der zweite Strang 30 statt den dritten Halbleiterbauelementen 4 zweite Halbleiterbauelemente 3 auf.

Mittels des Widerstandselements 6 kann dann einer Farbortverschiebung des Mischlichts in Richtung grüner Farbkoordinaten bei zunehmender Temperatur entgegengewirkt werden.

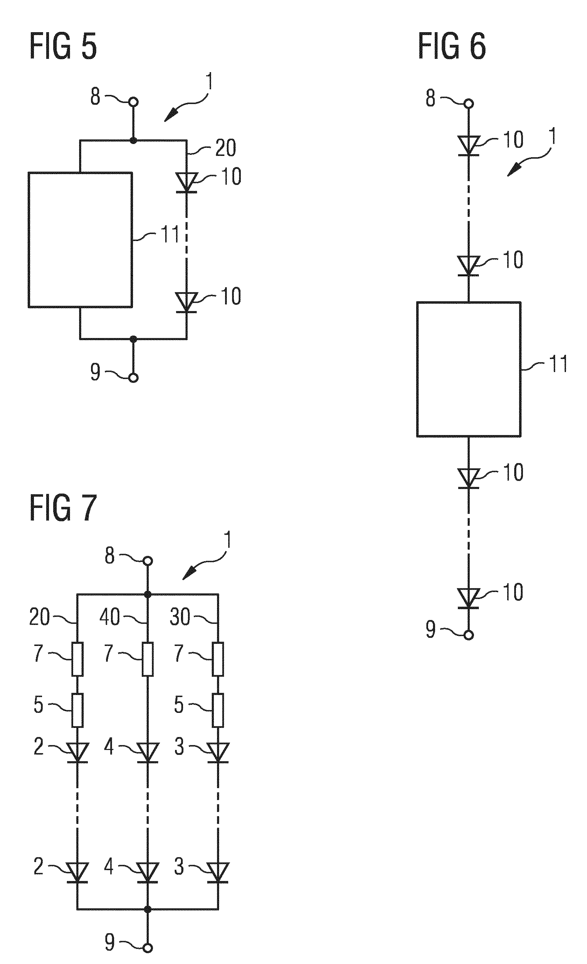

In Figur 5 ist das Ersatzschaltbild eines weiteren Ausführungsbeispiels eines Leuchtmoduls 1 gemäß der vorliegenden Anmeldung dargestellt.

Das Leuchtmodul 1 weist eine Anordnung 11, welche mindestens ein erstes, zweites und drittes Halbleiterbauelement (nicht bezeichnet) und mindestens ein Widerstandselement (nicht bezeichnet) umfasst, sowie mehrere vierte Halbleiterbauelemente 10 auf.

Die Anordnung 11 weist insbesondere eine wie im Zusammenhang mit den Figuren 1 bis 4 beschriebene Schaltung von ersten, zweiten und dritten Halbleiterbauelementen sowie mindestens einem Widerstandselement auf. Die vierten Halbleiterbauelemente 10 sind innerhalb eines Stranges 20 angeordnet und seriell verschaltet. Der Strang 20 aus seriell verschalteten vierten Halbleiterbauelementen 10 bildet eine Parallelschaltung mit der Anordnung 11.

Die vierten Halbleiterbauelemente 10 unterscheiden sich durch Lichtintensität und/oder Farbort des abgestrahlten Lichts von dem ersten, zweiten und dritten Halbleiterbauelement.

Durch die Parallelschaltung können vorteilhafterweise bei einer großen Anzahl von Halbleiterbauelementen zu hohe Spannungen vermieden werden. Weiterhin kann durch Zuschalten der vierten Halbleiterbauelemente 10 eine Anpassung an die Treiberelektronik vorgenommen werden.

In Figur 6 ist das Ersatzschaltbild eines weiteren Ausführungsbeispiels eines Leuchtmoduls 1 gemäß der vorliegenden Anmeldung dargestellt.

Das Leuchtmodul 1 weist eine Anordnung 11, welche mindestens ein erstes, zweites und drittes Halbleiterbauelement (nicht bezeichnet) und mindestens ein Widerstandselement (nicht bezeichnet) umfasst, sowie mehrere vierte Halbleiterbauelemente 10 auf.

Die Anordnung 11 weist insbesondere eine wie in Verbindung mit den Figuren 1 bis 4 beschriebene Schaltung von ersten, zweiten und dritten Halbleiterbauelementen sowie mindestens einem Widerstandselement auf. Die vierten Halbleiterbauelemente 10 sind zu der Anordnung 11 in Serie geschaltet. Bei dieser Verschaltung fällt das in der Anordnung 11 enthaltene Widerstandselement spannungstechnisch weniger stark ins Gewicht.

Die in den Figuren 5 und 6 dargestellten vierten Halbleiterbauelemente 10 können zum verbesserten schaltungstechnischen Betreiben des Leuchtmoduls 1 oder zur Verbesserung der Farbwiedergabe des von dem Leuchtmodul 1 abgestrahlten Mischlichts vorgesehen sein.

Im ersten Fall ist es vorteilhaft, wenn die vierten Halbleiterbauelemente 10 monochromatisches Licht in einem Wellenlängenbereich zwischen insbesondere 450 nm und 600 nm emittieren.

Im zweiten Fall ist es vorteilhaft, wenn die vierten Halbleiterbauelemente 10 konvertiertes, insbesondere gelbes Licht aussenden.

In Figur 7 ist das Ersatzschaltbild einer weiteren nicht beanspruchten Abwandlung eines Leuchtmoduls 1 dargestellt.

Das Leuchtmodul 1 weist einen Aufbau entsprechend der in Figur 1 dargestellten Abwandlung mit drei Strängen 20, 30, 40 von in Serie geschalteten ersten, zweiten und dritten Halbleiterbauelementen 2, 3, 4 auf, wobei den ersten und zweiten Halbleiterbauelementen 2, 3 jeweils ein Widerstandselement 5 mit einem negativen Temperaturkoeffizienten vorgeschaltet ist. Außerdem ist jeweils ein Widerstandselement 7 mit einem temperaturunabhängigen elektrischen Widerstand mit den ersten, zweiten und dritten Halbleiterbauelementen 2, 3, 4 in Serie geschaltet. Bevorzugt weisen die Widerstandselemente 7 einen ohmschen Widerstand auf. Weiter bevorzugt weisen die Widerstandselemente 7 einen programmierbaren elektrischen Widerstand auf. Der elektrische Widerstand kann in die Widerstandselemente 7 fest einprogrammiert werden, sodass sich bei dem Leuchtmodul 1 ein dauerhafter Offset des Farborts ergibt. Durch einen dauerhaften Offset des Farborts können beispielsweise Fertigungstoleranzen oder Sättigungsschwankungen ausgeglichen werden.

Derartige Widerstandselemente 7 mit einem temperaturunabhängigen elektrischen Widerstand können auch in den Leuchtmodulen 1 gemäß den Figuren 2 bis 6 vorgesehen werden.

## Patentansprüche

1. Leuchtmodul (1) zur Abstrahlung von Mischlicht mit einem bei zunehmender Temperatur temperaturstabilen Farbort umfassend:
- mindestens ein erstes Halbleiterbauelement (2), das unkonvertiertes rotes Licht abstrahlt,
- mindestens ein zweites Halbleiterbauelement (3), das konvertiertes grünlich-weißes Licht mit einem ersten Konversionsanteil abstrahlt,
- mindestens ein drittes Halbleiterbauelement (4), das konvertiertes grünlich-weißes Licht mit einem zweiten Konversionsanteil abstrahlt, der kleiner ist als der erste Konversionsanteil, wobei das zweite und das dritte Halbleiterbauelement (3, 4) jeweils ein Konversionselement aufweisen,
- mindestens ein Widerstandselement (5, 6) mit einem temperaturabhängigen elektrischen Widerstand, wobei das mindestens eine Widerstandselement (5, 6) einen positiven Temperaturkoeffizienten aufweist,
**dadurch gekennzeichnet, dass**
- die Konversionselemente einen positiven Temperaturkoeffizienten aufweisen,
- das mindestens eine zweite Halbleiterbauelement (3) mit dem mindestens einen Widerstandselement (5, 6) eine Serienschaltung bildet,
- die Serienschaltung mit einem Strang (20), der das mindestens eine erste Halbleiterbauelement (2) umfasst, und mit einem weiteren Strang (40), der das mindestens eine dritte Halbleiterbauelement (4) umfasst, parallel geschaltet ist, oder mit einem Strang (20), der das mindestens eine erste Halbleiterbauelement (2) in Serie mit dem mindestens einen dritten Halbleiterbauelement (4) umfasst, parallel geschaltet ist.

2. Leuchtmodul (1) nach dem vorherigen Anspruch, wobei ein Strom durch das mindestens eine erste Halbleiterbauelement (2) mit steigender Temperatur abnimmt.

## Claims

1. Lighting module (1) for emitting mixed light having a colour locus that is temperature-stable as the temperature increases, comprising:
- at least one first semiconductor component (2) which emits unconverted red light,
- at least one second semiconductor component (3) which emits converted greenish-white light having a first conversion proportion,
- at least one third semiconductor component (4) which emits converted greenish-white light having a second conversion proportion, which is less than the first conversion proportion, wherein the second and the third semiconductor component (3, 4) each comprise a conversion element,
- at least one resistance element (5, 6) having a temperature-dependent electrical resistance, wherein the at least one resistance element (5, 6) has a positive temperature coefficient,
**characterized in that**
- the conversion elements have a positive temperature coefficient,
the at least one second semiconductor component (3) forms a series circuit with the at least one resistance element (5, 6),
- the series circuit is connected in parallel with a string (20) comprising the at least one first semiconductor component (2) and with a further string (40) comprising the at least one third semiconductor component (4), or is connected in parallel with a string (20) comprising the at least one first semiconductor component (2) in series with the at least one third semiconductor component (4).

2. Lighting module (1) according to the preceding claim, wherein a current through the at least one first semiconductor component (2) decreases as the temperature rises.

## Revendications

1. Module lumineux (1) destiné à émettre une lumière mélangée ayant une localisation chromatique stable en température lorsque la température croît, comprenant:
- au moins un premier composant à semi-conducteur (2) qui émet une lumière rouge non convertie,
- au moins un deuxième composant à semi-conducteur (3) qui émet une lumière vert-blanc convertie avec un premier taux de conversion,
- au moins un troisième composant à semi-conducteur (4) qui émet une lumière vert-blanc convertie avec un deuxième taux de conversion qui est inférieur au premier taux de conversion, dans lequel les deuxième et troisième composants à semi-conducteur (3, 4) comportent respectivement un élément de conversion,
- au moins un élément résistif (5, 6) présentant une résistance électrique dépendant de la température, dans lequel l'élément résistif (5, 6) présente un coefficient de température positif,
**caractérisé en ce que**
- les éléments de conversion présentent un coefficient de température positif,
- l'au moins un deuxième composant à semi-conducteur (3) comportant l'au moins un élément résistif (5, 6) forme un circuit série,
- le circuit série est connecté en parallèle à une ligne (20) qui comprend l'au moins un premier composant à semi-conducteur (2) et à une autre ligne (40) qui comprend l'au moins un troisième composant à semi-conducteur (4), ou est connecté en parallèle à une ligne (20) qui comprend l'au moins un premier composant à semi-conducteur (2) en série avec l'au moins un troisième composant à semi-conducteur (4).

2. Module lumineux (1) selon la revendication précédente, dans lequel un courant passant à travers l'au moins un premier composant à semi-conducteur (2) diminue lorsque la température croît.
